# FASCICULE DE BREVET EUROPEEN

(11) **EP 0 360 660 B1**
(45) Date de publication et mention de la délivrance du brevet: **18.11.1993**
(21) Numéro de dépôt: 89402478.5
(22) Date de dépôt: 12.09.1989
(51) Int. Cl.: H01L 25/075, H01L 33/00

(54) **Réseau de diodes électroluminescentes**
Anordnung von lichtemittierenden Dioden
Light-emitting diode array

(30) Priorité: 23.09.1988 FR 8812436
(43) Date de publication de la demande: 28.03.1990
(73) Titulaire: VALEO VISION, 93012 Bobigny Cédex (FR)
(72) Inventeur: Le Creff, René, F-89100 - Sens (FR)
(74) Mandataire: Lemaire, Marc

(56) Documents cités:
- EP-A- 0 088 060
- EP-A- 0 184 877
- FR-A- 2 518 317
- FR-A- 2 565 726

## Description

La présente invention concerne un réseau de diodes électroluminescentes constitué d'une pluralité de cristaux semi-conducteurs dont l'une et l'autre des deux régions P et N de types de conduction opposés sont respectivement et sélectivement mises en contact avec des éléments de connexion.

On utilise de plus en plus de tels réseaux, comme par exemple pour remplacer les lampes à incandescence ou fluorescence des appareils d'éclairage, comme de même pour les feux de signalisation, de stop, clignotants et dispositifs de visualisation de sécurité pour véhicules automobiles.

Les réseaux de diodes électroluminescentes souvent utilisés actuellement ont leurs cristaux semi-conducteurs disposés sur des plages de connexion agencées selon une configuration préalablement choisie sur un élément support isolant de manière que chacune desdites plages conductrices d'alimentation électrique soit respectivement et sélectivement mise en contact de l'une et l'autre des deux régions P et N de types de conduction opposés de chacun des cristaux électroluminescents semi-conducteurs composant le réseau. Cet assemblage est conçu pour une technique de montage de composants électroniques en grandes surfaces, c'est-à-dire un assemblage modulaire à pas constant adapté au soudage direct de l'embase-anode P des cristaux semi-conducteurs, à l'aide de résines conductrices qui ne se polymérisent qu'à des températures de l'ordre de 200°C, et surtout au soudage de fils d'or de connexion cathode N dont est pourvue l'autre zone de liaison électrique de chacun des cristaux.

Ce procédé d'assemblage s'adapte très mal aux circuits imprimés conçus pour le montage de composants électroniques pré-étamés et soudés à la vague à des températures relativement basses et autres réseaux de connexions rapportées sur des supports isolants en matériaux plastiques pouvant être dégradés par les températures nécessaires au soudage des cristaux électroluminescents. Egalement, dans le plus grand nombre d'applications connues, les éléments électroluminescents qui forment généralement une matrice de diodes semi-conductrices doivent être disposés en quantité importante sur une surface réduite et l'émission des rayonnements de chacun d'entre eux doit, entre autres, être localisée dans une zone sensiblement ponctuelle, leur intensité lumineuse étant renforcée par la suite à l'aide d'un système optique approprié.

Le brevet FR-A-2.574.616 montre un tel système optique dans lequel l'assemblage, d'une part, d'une pluralité de diodes électroluminescentes portées ou non par un support spécifique inséré sur un substrat isolant et, d'autre part, d'un système d'éléments optiques de collimation devant de préférence constituer un jeu de réflecteurs paraboliques, chacun sensiblement de même axe optique que le cristal semi-conducteur qui lui correspond, doit répondre à une certaine directivité du faisceau lumineux.

Par ailleurs, malgré la faible consommation de courant des éléments électroluminescents, leur accumulation sur la matrice du support isolant qui les porte conduit à des problèmes thermiques qui ont des répercussions également sur l'efficacité lumineuse. On a pu relever ainsi qu'une élévation de la température de l'assemblage due à la puissance dissipée par 50 diodes (de l'ordre de 4 watts), conduisait à une diminution du rendement lumineux dans un rapport pouvant atteindre 0,7 % par °C.

Cette élévation de température peut parvenir également dans certains cas et configurations à provoquer des dégradations de la plupart des matériaux, tels que matières plastiques, qui constituent généralement le réflecteur ou ses couches de revêtement possibles déposées par un procédé de métallisation sous vide et vernissage de protection éventuelle.

Dans la demande de brevet FR-A-2.565.726, il est proposé de fixer des diodes électroluminescentes sur une première bande métallique constituant une connexion électrique de première polarité, une seconde bande métallique constituant une connexion électrique de seconde polarité est reliée à chacune des diodes électroluminescentes par un fil de connexion. Un tel montage ne permet cependant pas d'obtenir une évacuation suffisante de la chaleur dégagée en fonctionnement et présente en outre une fragilité due à l'existence de fils de connexion susceptibles de se rompre ou de se déconnecter sous l'effect de l'échauffement et des vibrations inhérentes à une utilisation sur véhicule automobile.

La présente invention a donc en conséquence pour but de remédier aux inconvénients précités et concerne à cet effet un réseau de diodes électroluminescentes constitué d'une pluralité de cristaux semi-conducteurs dont l'une et l'autre des deux régions P et N de types de conduction opposés formant une jonction électroluminescente, sont respectivement et sélectivement mises en contact avec des éléments de connexion, caractérisé en ce qu'il comprend au moins une bande de diodes électroluminescentes constituée essentiellement d'une pluralité de cristaux semi-conducteurs disposés, espacés les uns derrière les autres, entre deux barrettes de connexion mises en contact directement et respectivement avec les régions P et N desdits cristaux semi-conducteurs.

Les barrettes de connexion sont avantageusement réalisées à partir d'un fil en matériau bon conducteur électrique et de très bonne conductivité thermique, comme le cuivre, l'aluminium, éventuellement le laiton et le zinc. Chacune des barrettes est conformée pour présenter une suite de deux séries de secteurs plans alternativement perpendiculaires les uns d'une série par rapport aux autres d'une autre série.

Les secteurs plans d'une des séries sont orientés parallèlement aux régions de contact de chacune des cristaux semi-conducteurs pour y être assemblés par soudage direct.

Les secteurs plans d'une desdites séries forment des ailettes de refroidissement pour la dissipation de la chaleur dégagée en fonctionnement.

Les secteurs plans de l'autre série, disposés perpendiculairement entre les secteurs plans de la première série, se déploient à l'extérieur des côtés latéraux de la bande à diodes électroluminescentes.

D'autres caractéristiques et avantages de l'invention seront mieux compris à l'aide de la description détaillée ci-dessous et du dessin annexé sur lequel :
- la figure 1 représente, en perspective et à grande échelle, une portion de bande de diodes électroluminescentes conforme à l'invention ;
- la figure 2 représente l'une des diodes électroluminescentes de la bande de la figure 1 sur les éléments radiateur et de connexion de laquelle un élément optique de collimation qui, lui correspondant, est disposé.

Conformément à l'invention, la bande de diodes électroluminescentes 1 est constituée d'une pluralité de cristaux semi-conducteurs 1a, avantageusement de forme cubique, disposés selon un intervalle constant les uns derrière les autres entre deux barrettes métalliques 2 et 3.

De manière connue en soi, dans chacun des cristaux 1a sont créées au moins deux régions de types de conduction opposés formant une jonction électroluminescente.

Chacune des barrettes 2,3 est obtenue à partir d'un fil en matériau bon conducteur électrique et de très bonne conductivité thermique.

Ce fil est conformé de manière à constituer une suite de deux séries de secteurs plans 5,6 alternativement perpendiculaires les uns par rapport aux autres.

Les secteurs plans 5 d'une première série sont orientés parallèlement aux régions de contact 4 de chaque cristal 1a pour y être assemblés par soudage direct à l'aide de résines conductrices à haute température de polymérisation.

Les autres secteurs 6, disposés selon une seconde série perpendiculairement entre les secteurs 5 de la première série correspondant à la zone d'intervalle entre les cristaux semi-conducteurs 1a, se déploient vers l'extérieur des côtés latéraux de la bande de diodes électroluminescentes 1.

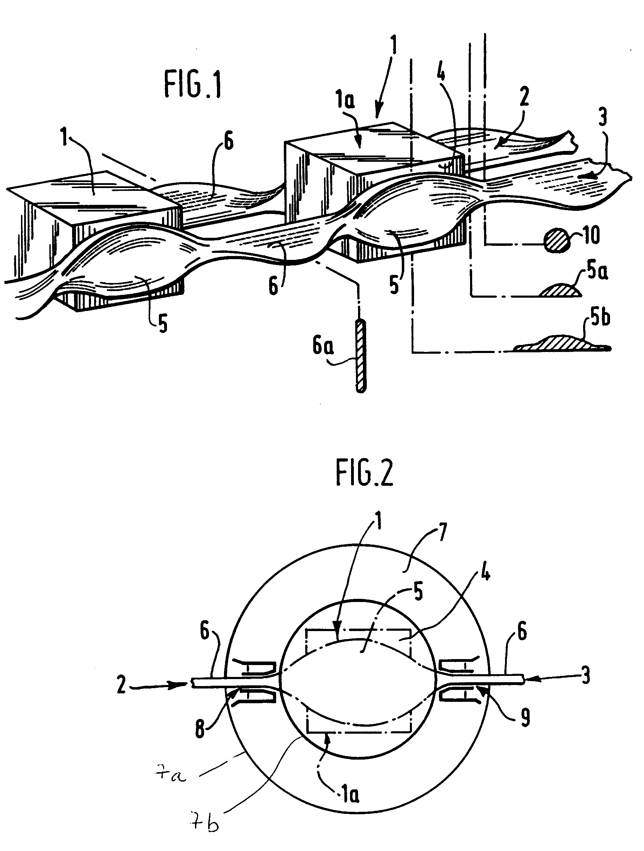

On peut voir sur la figure 1 les diverses sections 5a, 5b et 6a obtenues après le formage du fil rond 10.

Les secteurs 6 engendrent une suite de plages métalliques de prise de contact qui constituent proprement dit les éléments de connexion extérieure, isolés entre eux, des cristaux semi-conducteurs 1a d'une part, et forment en même temps des éléments radiateurs en forme d'ailettes, appropriés à évacuer les calories dissipées par les deux régions opposées de la jonction électroluminescente des cristaux semi-conducteurs 1a d'autre part.

Le fil dans lequel sont conformées les deux barrettes 2,3 peut être en cuivre, aluminium, laiton ou zinc. Ces matériaux sont très appropriés pour constituer les éléments radiateurs des matériaux électroluminescents sans recourir à des placages d'or ou d'argent.

Cette réalisation de bande à diodes 1, dont les cristaux sensiblement cubiques 1a émettent de la lumière par la tranche, présente de nombreux avantages dus notamment à sa forme particulière, au choix des matériaux et techniques d'assemblage employés et à la simplicité de sa réalisation qui permet une automatisation aisée.

Le fait de réaliser une série de cristaux 1a en bande, par association à pas constant entre deux barrettes de longueur 2,3 formant les éléments radiateur et de connexion directe 5,6, nécessaires à chacune des deux régions de contact de la jonction, facilite leur assemblage et leur agencement à tout support isolant portant le ou les éléments optiques, tels des réflecteurs paraboliques 7.

C'est ainsi que le support isolant ne nécesite pas l'utilisation d'une matière ayant de très bonnes caractéristiques de dissipation thermique, mais onéreuse.

Sur la figure 2 on a représenté, à titre d'exemple non exhaustif, le positionnement d'une des diodes élémentaires 1 dans le fond d'un réflecteur élémentaire 7 dont les limites apparentes sont figurées en 7a et 7b pourvu à cet effet de rainures 8 et 9 qui insèrent sélectivement et directement les plages de liaison électrique des secteurs 6 de l'une des barrettes 2,3.

Les cristaux semi-conducteurs 1a sont ainsi mis en place avec précision au foyer du réflecteur 7 qui peut ainsi au mieux transmettre toute la lumière émise en son centre focal par la tranche dudit cristal semi-conducteur 1.

Il est possible de produire des bandes de diodes 1 relativement longues, puis de les sectionner à la longueur voulue et de les juxtaposer en les interconnectant en série et/ou en parallèle.

## Revendications

1. Réseau de diodes électroluminescentes constitué d'une pluralité de cristaux semi-conducteurs (1) dont l'une et l'autre des régions P et N de types de conductions opposés formant une jonction électroluminescente, sont respectivement et sélectivement mises en contact avec des éléments de connexion (2,3), caractérisé en ce qu'il comprend au moins une bande de diodes électroluminescentes constituée essentiellement d'une pluralité de cristaux semi-conducteurs (1) disposés, espacés les uns derrière les autres, entre deux barrettes de connexion (2,3) mises en contact directement et respectivement avec les régions P et N desdits cristaux semi-conducteurs (1).

2. Réseau de diodes électroluminescentes selon la revendication 1, caractérisé en ce que chacune des barrettes (2,3) est conformée pour présenter une suite de deux séries de secteurs plans (5,6) alternativement perpendiculaires les uns d'une série (5) par rapport aux autres (6) d'une autre série.

3. Réseau de diodes électroluminescentes selon la revendication 1 ou 2, caractérisé en ce que les barrettes (2,3) sont réalisées à partir d'un fil métallique (10) bon conducteur électrique et de bonne conductivité thermique comme le cuivre, l'aluminium, le laiton et le zinc.

4. Réseau de diodes électroluminescentes selon la revendication 2, caractérisé en ce que les secteurs plans (5) d'une des séries sont orientés parallèlement aux régions de contact (4) de chacun des cristaux semi-conducteurs (1) pour y être assemblés par soudage direct.

5. Réseau de diodes électroluminescentes selon la revendication 4, caractérisé en ce que les secteurs plans (6) de l'autre série, disposés perpendiculairement entre les secteurs (5) de la première série se déplient à l'extérieur des côtés latéraux de la bande à diodes électroluminescentes, en formant des ailettes de refroidissement.

6. Réseau de diodes électroluminescentes selon la revendication 5, caractérisé en ce que les plages de liaison électrique des secteurs plans (6) disposées de part et d'autre des diodes électroluminescentes sont aptes à positionner chaque cristal semi-conducteur (1) élémentaire au foyer d'un réflecteur (7) d'un élément optique qu'ils supportent.

## Claims

1. A network of light emitting diodes comprising a plurality of semiconductor crystals (1), whereof p-type and n-type regions, of opposed conductivity types and defining a light emitting junction, are respectively and selectively in contact with connecting elements (2, 3), characterised in that it includes at least one band of light emitting diodes comprising essentially a plurality of semiconductor crystals (1), which are disposed in spaced relationship one behind another between two connecting strips (2, 3) which are in contact directly and respectively with the p-type and n-type regions of the said semiconductor crystals (1).

2. A network of light emitting diodes according to Claim 1, characterised in that each of the strips (2, 3) is so configured as to present a succession of two series of alternating flat sectors (5, 6), with those of one series (5) being perpendicular with respect to the others (6) in another series.

3. A network of light emitting diodes according to Claim 1 or Claim 2, characterised in that the strips (2, 3) are made from a metallic wire (10) which is a good electrical conductor and which has good thermal conductivity, for example copper, aluminium, brass and zinc.

4. A network of light emitting diodes according to Claim 2, characterised in that the flat sectors (5) of one of the series are orientated parallel to the contact regions (4) of each of the semiconductor crystals (1) so as to be assembled therewith by direct soldering.

5. A network of light emitting diodes according to Claim 4, characterised in that the flat sectors (6) of the other series, disposed perpendicularly between the sectors (5) of the first series, extend outwardly of the lateral sides of the band of light emitting diodes, so as to define cooling fins.

6. A network of light emitting diodes according to Claim 5, characterised in that the electrical contact areas of the flat sectors (6) disposed on either side of the light emitting diodes are adapted to position each elementary semiconductor crystal (1) at the focus of a reflector (7) of an optical element which they support.

## Patentansprüche

1. Anordnung von lichtemittierenden Dioden, bestehend aus einer Vielzahl von Halbleiterkristallen (1), deren Zonen P und N mit entgegengesetzter Leitung einen lichtemittierenden Übergang bilden und die jeweils selektiv mit Verbindungselementen (2, 3) in Kontakt gebracht werden, **dadurch gekennzeichnet,** daß sie wenigstens ein Band aus lichtemittierenden Dioden enthält, bestehend im wesentlichen aus einer Vielzahl von Halbleiterkristallen (1), die in Abständen hintereinander zwischen zwei Verbindungsschienen (2, 3) angeordnet sind, welche direkt mit den Zonen P bzw. N der genannten Halbleiterkristalle (1) in Kontakt stehen.

2. Anordnung von lichtemittierenden Dioden nach Anspruch 1, **dadurch gekennzeichnet,** daß jede der Schienen (2, 3) so ausgebildet ist, daß sie eine Folge von zwei Serien von flachen Sektoren (5, 6) bildet, von denen die Sektoren einer Serie (5) abwechselnd lotrecht im Verhältnis zu den anderen (6) Sektoren einer anderen Serie angeordnet sind.

3. Anordnung von lichtemittierenden Dioden nach Anspruch 1 oder 2, **dadurch gekennzeichnet,** daß die Schienen (2, 3) aus einem Metalldraht (10) hergestellt sind, der eine gute elektrische Leitfähigkeit und eine gute Wärmeleitfähigkeit besitzt, wie zum Beispiel Kupfer, Aluminium, Messing und Zink.

4. Anordnung von lichtemittierenden Dioden nach Anspruch 2, **dadurch gekennzeichnet,** daß die flachen Sektoren (5) einer der Serien parallel zu den Kontaktzonen (4) jedes der Halbleiterkristalle (1) ausgerichtet sind, um damit direkt verschweißt zu werden.

5. Anordnung von lichtemittierenden Dioden nach Anspruch 4, **dadurch gekennzeichnet,** daß die flachen Sektoren (6) der anderen Serie, die lotrecht zwischen den Sektoren (5) der ersten Serie angeordnet sind, sich außerhalb der Seitenflächen des Bands mit lichtemittierenden Dioden entfalten und dadurch Kühlrippen bilden.

6. Anordnung von lichtemittierenden Dioden nach Anspruch 5, **dadurch gekennzeichnet,** daß die elektrischen Verbindungsflächen der flachen Sektoren (6), die beiderseits der lichtemittierenden Dioden angeordnet sind, geeignet sind, jedes elementare Halbleiterkristall (1) im Brennpunkt eines Reflektors (7) eines darauf ruhenden optischen Elements zu positionieren.
